Europäisches Patentamt

European Patent Office

Office européen des brevets

(11) Publication number: **0 028 103**
**B1**

# EUROPEAN PATENT SPECIFICATION

(45) Date of publication of patent specification: **08.08.84**

(51) Int. Cl.³: **G 10 L 1/08, G 01 R 23/167**

(21) Application number: **80303655.7**

(22) Date of filing: **16.10.80**

(54) **A spectrum analyzer.**

(30) Priority: **23.10.79 JP 136890/79**

(43) Date of publication of application:
**06.05.81 Bulletin 81/18**

(45) Publication of the grant of the patent:
**08.08.84 Bulletin 84/32**

(84) Designated Contracting States:
**DE FR GB**

(56) References cited:
**US - A - 4 157 457**

**PROCEEDINGS OF THE NATIONAL
ELECTRONICS CONFERENCE, vol. XI, 3rd-5th
October 1955, pages 212-221 Oak Brook, U.S.A.
F.H. KISHI et al.: "Analysis of low-frequency
noise using high-pass filters and analog-
computer techniques"**

**IBM TECHNICAL DISCLOSURE BULLETIN, vol.
16, no. 2, July 1973, pages 573,574 New York,
U.S.A. R. BAKIS et al.: "Fast digital filterbanks
for speech processing"**

(73) Proprietor: **FUJITSU LIMITED
1015, Kamikodanaka Nakahara-ku
Kawasaki-shi Kanagawa 211 (JP)**

(72) Inventor: **Hanahara, Keishi
3673-33, Shimotsuruma
Yamato-shi Kanagawa 242 (JP)**

(74) Representative: **Bedggood, Guy Stuart et al,
Haseltine Lake & Co. Hazlitt House 28
Southampton Buildings Chancery Lane
London WC2A 1AT (GB)**

Courier Press, Leamington Spa, England.

**Description**

This invention relates to a spectrum analyser.

When following changes on the time axis of the power distribution of a voice spectrum, for example, which is one method of voice information extraction used in voice recognition units and voice analysers, the voice frequency band is divided into several channels in order to obtain such a power distribution. Band-pass filters corresponding to the respective channels are provided, and the output power of each band-pass filter is rectified and smoothed with a specified time interval, thereby voice analysis data can be obtained. Bandpass filters equal in number to the channels are required, and thus expensive band-pass filters of the same number as the number of voice analysis channels are required for a voice recognition unit. Generally, ten or more band-pass filters are required.

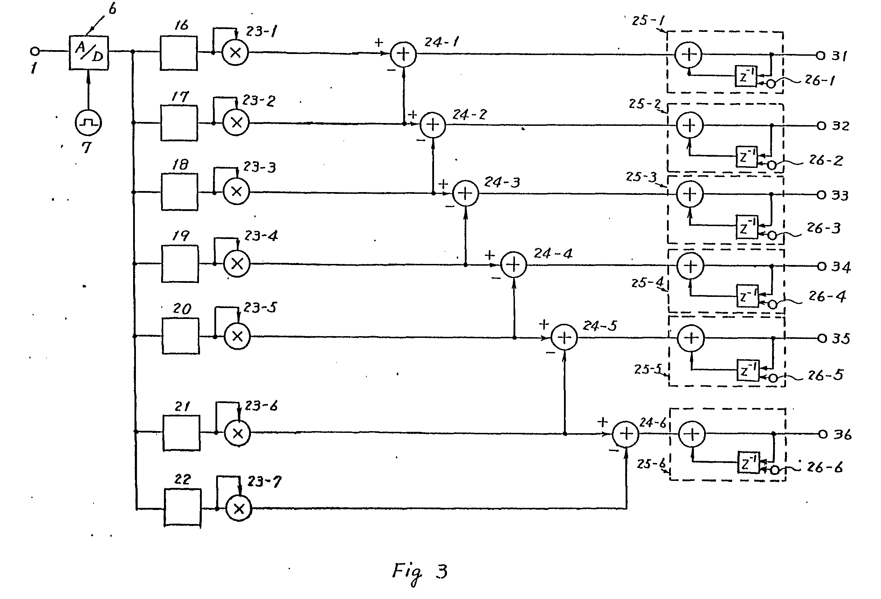

Proceedings of the National electronics conference, October 3 to 5, 1955, Chicago, Illinois, Volume XI, discloses at pages 214 to 221 (see Fig. 3) a high-pass filter spectrum analyzer. The disclosed high-pass filter spectrum analyzer has a plurality of high-pass analog filters. The digital process was ruled out because conversion to digital form made the filter process very slow. The disclosed filter also has a plurality of squaring circuits, one connected to receive the signal to be analysed via a rectifier the others connected via respective rectifiers for receiving the outputs of respective filters. A plurality of integrators are connected respectively to receive the outputs of the squaring circuits. A plurality of summers are connected each to receive the output of one integrator and, via an inverter, the output of another integrator. The summers deliver the outputs of the analyzer.

According to the present invention there is provided a sprectrum analyzer, having a plurality of low (or high) pass filters connected for receiving in parallel a signal to be analysed, a plurality of square circuits connected to respective filters, a plurality of accumulators, and a plurality of subtraction circuits characterised in that the plurality of subtraction circuits are connected for receiving signals directly from the outputs of respective pairs of square circuits each for deriving the difference between the signals from the outputs of the square circuits of the pair concerned, each such pair of square circuits being connected respectively to one filter and to another filter of the next highest, or next lowest, cut-off frequency, and in that the plurality of accumulators are connected to respective subtraction circuits to receive outputs therefrom.

It will be understood that pairs differing in only one member are different pairs.

An embodiment of the present invention can provide for the elimination of the disadvantages mentioned above by providing a spectrum analyzer using low cost digital low- (or high-) pass filters $n + 1$ in number, in place of band-pass filters $n$ in number ($n$ = number of channels of the analyzer).

An embodiment of this invention provides for the realization of a band-pass filter by a parallel connection of a couple of digital low- (or high-) pass filters, and utilizes the fact that data actually required for spectrum analyses (e.g. voice spectrum analysis) is the power obtained from each channel.

An embodiment of this invention comprises digital/analog converters, digital low- (or high-) pass filters, square circuits, subtraction circuits and accumulators.

Operations in an embodiment of this invention can be understood on the following theoretical basis.

$n$ band-pass filters, one for each channel, required when the frequency bands of the $n$ channels are continuous (i.e. where the upper limit of one channel is substantially contiguous with the lower limit of a next channel), are effectively realized by means of $n + 1$ digital low- (or high-) pass filters.

In general, to realize a band-pass filter the number of orders (orders of the transfer function of a filter) is almost doubled as compared with that of a digital low- (or high-) pass filter having a similar frequency cut-off characteristic. However, according to this invention, a band-pass filter can be realized with the number of orders which is about half the existing requirement. This is because one digital low- (or high-) pass filter can be used in common to two adjacent frequency bands. Therefore, the number of multiplications required can be reduced by half as compared with that of an existing method wherein a band-pass filter is directly provided. Thereby, an economical improvement can be attained through a specific cost reduction.

Reference is made, by way of example, to the accompanying drawings, in which:

Figure 1 is a schematic block diagram of a conventional spectrum analyzer;

Figure 2(a) is a schematic block diagram for assistance in explanation of basic features of this invention;

Figure 2(b) is a graphical representation of digital low-pass filter transmission characteristics for further assistance;

Figures 3 and 4 are respective schematic block diagrams of respective embodiments of this invention; and

Figure 5 is a graphical representation of digital low-pass filter characteristics for assistance in explanation of operation of the embodiments of Figures 3 and 4.

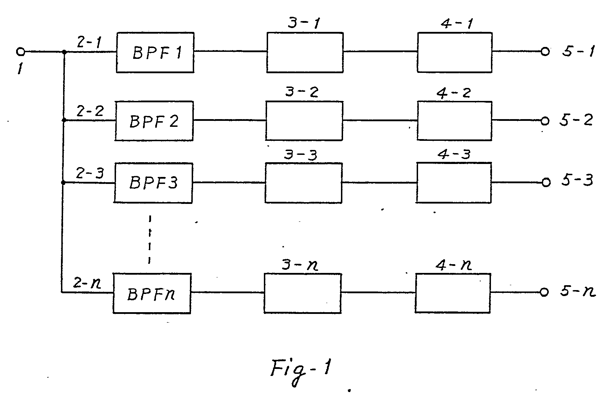

In Figure 1, 1 is an input terminal; 2—1, 2—2, 2—3 to 2—$n$ are band-pass filters for respective channels which correspond to continuous voice frequencies. That is to say, the respective channels deal with respective frequency bands which are continuous from one channel to the next. The upper limit of the frequency band of one channel is contiguous with the lower limit of the frequency band of the next

2

channel. 3—1 to 3—*n* are full-wave rectifiers; 4—1 to 4—*n* are integral circuits; 5—1, 5—2, 5—3 to 5—*n* are output terminals from which spectrum analysis outputs for each voice channel are delivered.

In the analyzer of Figure 1, a voice signal delivered to the input terminal 1 is divided into voice channel frequency bands by the respective band-pass filters 2—1, 2—2, 2—3 to 2—*n*. The frequencies of each channel are doubled by the full-wave rectifiers 3—1 to 3—*n* and the outputs of such rectifiers are integrated respectively by the integral circuits 4—1 to 4—*n*. Thereby, mean (power) values of bands of the spectrum, in a certain time interval, are output from output terminals 5—1, 5—2, 5—3 to 5—*n*. Thus, a spectrum analyzer is formed.

As explained above, the prior art analyzer requires a band-pass filter for each channel, for the purpose of spectrum analysis of each channel.

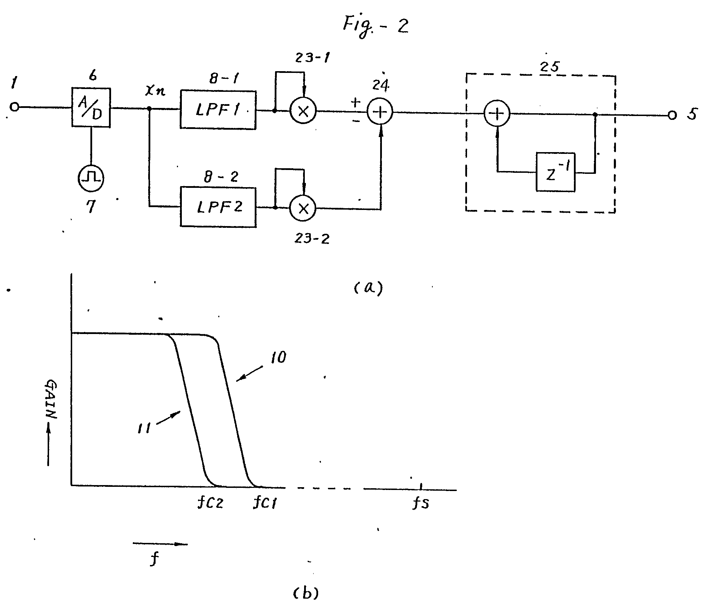

The present invention will be explained with reference to the schematic block diagrams of Fig. 2 to Fig. 4.

First, principles of the present invention will be explained by referring to Fig. 2 (a) and (b).

In Fig. 2(a), 1 is an input terminal (as in Fig. 1); 5 is an output terminal; 6 is an analog/digital converter (hereinafter referred to as A/D converter); 7 is a clock pulse source for use in sampling an input signal from the input terminal; 8—1, 8—2 are digital low-pass filters (cut-off frequencies, $f_{c1}$, $f_{c2}$ respectively); 23—1, 23—2 are square circuits; 24 is a subtraction circuit; 25 is an accumulator which accumulates, for example, the outputs of subtraction circuit 24 over a time interval of 10 msec and then outputs the accumulated memory value simultaneously with clearing of the accumulator by a clear pulse; and $Z^{-1}$ is a delay circuit.

In Figure 2(b), curves 10 and 11 illustrate the transmission characteristics of the digital low-pass filters 8—1, 8—2 of Figure 2(a) respectively.

In Figure 2(b), the horizontal axis indicates frequency f, the vertical axis indicates transmission gain, $f_{c1}$, $f_{c2}$ respectively indicate the cut-off frequencies of the digital low-pass filters 8—1, 8—2, and $f_s$ is the sampling frequency of source 7.

In Figure 2(a), the voice signal input delivered to the input terminal 1 is sampled in response to sampling pulses sent from the sampling pulse source 7 in the A/D converter 6. A sampled digital signal series is input to digital low-pass filter 8—1 having the transmission characteristic 10 as shown in Figure 2(b), which provides an output y1(n). The sampled signal series output from the A/D converter 6 is also input to the digital low-pass filter 8—2 having the transmission characteristic 11, providing an output y2(n).

The respective outputs of the digital low-pass filters 8—1, 8—2 are squared by the square circuits 23—1, 23—2 and outputs y1(n)$^2$, y2(n)$^2$ are obtained. The outputs of square circuits 23—1, 23—2 are subject to subtraction in the subtraction circuit 24. The result is input to the accumulator 25. The values of data fed thereto are memorised and accumulated in the accumulator 25 (which is a complete integral circuit) over a period of 10 msec and then output from the accumulator. Simultaneously, the accumulator memory value is cleared. The output value from the accumulator is proportional to the signal energy within the frequency band $f_{c1}$—$f_{c2}$ and this accumulated value is output as voice spectrum analysis information.

The result achieved above can be explained mathematically as indicated below.

The transfer function of a band-pass filter is taken to be H(z) and the transfer functions of the digital low-pass filters 8—1, 8—2 are taken to be $H_1(z)$ and $H_2(z)$ respectively. When Z conversions of an input signal series $x_n$ fed to a band-pass filter, and an output $y_n$ of the band-pass filter are written as X(z) and Y(z) respectively, the Parseval relationship expressed by equation (1) can be obtained:—

$$\sum_{n=-\infty}^{\infty} |y(n)|^2 = \tfrac{1}{2}\pi \int_{-\pi}^{\pi} |Y(e^{jw})|^2 \, dw \qquad \quad .. (1)$$

where, $\omega = f/f_s$ ($f_s$ is the sampling frequency).

On the other hand, since Y(z) = H(z).X(z) the equation (1) can be transformed into equation (2):—

$$\sum_{n=-\infty}^{\infty} |y(n)|^2 = \tfrac{1}{2}\pi \int_{-\pi}^{\pi} |H(e^{jw})|^2 \cdot |X(e^{jw})|^2 \, dw \qquad \quad ... (2)$$

Here, assuming an ideal band-pass filter and ideal low-pass filters, since

$$|H(e^{jw})|^2 = |H_1(e^{jw})|^2 - |H_2(e^{jw})|^2 \qquad \quad ... (3)$$

3

equation (2) can be transformed as follows:—

$$\sum_{n=-\infty}^{\infty} |y(n)|^2 = \tfrac{1}{2}\pi \int_{-\pi}^{\pi} |H_1(e^{jw})|^2 \cdot |X(e^{jw})|^2 \, dw$$

$$- \tfrac{1}{2}\pi \int_{-\pi}^{\pi} |H_2(e^{jw})|^2 \cdot |X(e^{jw})|^2 \, dw$$

$$= \sum_{n=-\infty}^{\infty} |y1(n)|^2 - \sum_{n=-\infty}^{\infty} |y2(n)|^2$$

$$= \sum_{n=-\infty}^{\infty} \{ |y1(n)|^2 - |y2(n)|^2 \} \qquad \qquad ..(4)$$

Equation (4) corresponds to the structure of the block diagram of Figure 2(a).

A structure wherein $n$ band-pass filters used for a spectrum analyzer can be replaced by $n + 1$ digital low-pass filters will be explained on the basis of the aforementioned principles.

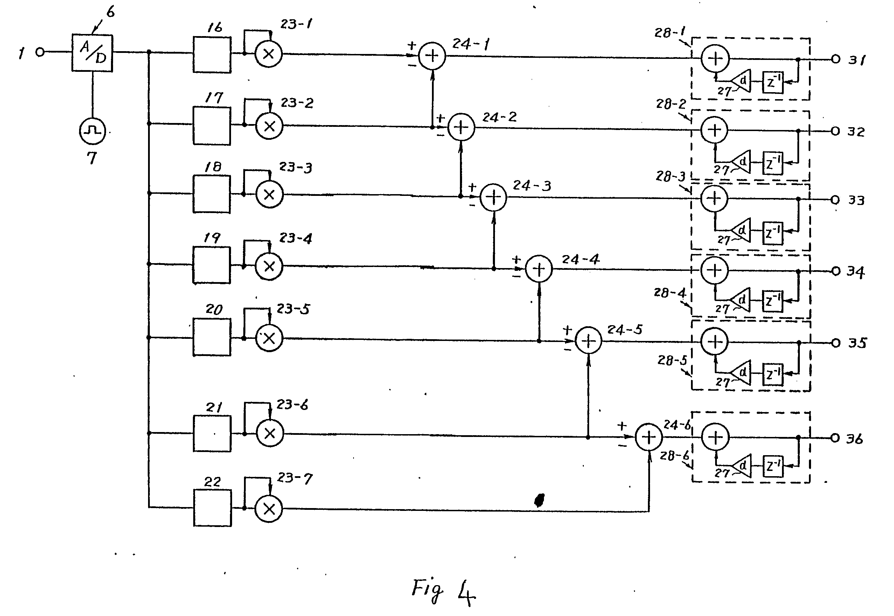

Figure 3 and Figure 4 illustrate embodiments of this invention, wherein the functions of $n$ band-pass filters are provided through the use of $n + 1$ digital low-pass filters.

In Figures 3, 1 is an input terminal; 6 is an A/D conversion circuit; 7 is a sampling pulse source; 16 to 22 are digital low-pass filters; 23—1 to 23—7 are square circuits; 24—1 to 24—6 are subtraction circuits; 25—1 to 25—6 are accumulators; 26—1 to 26—6 are input terminals for clear pulses for clearing previously memorised values of the accumulators; 31, 32, 33, 34, 35, 36, are output terminals.

In Figure 4, the accumulators 28—1 to 28—6 are each provided with a co-efficient circuit 27. Thereby, the accumulators become imperfect integral circuits and provide that it is not necessary to clear previous data when accumulating new data to be input.

Now, circuit operations will be explained.

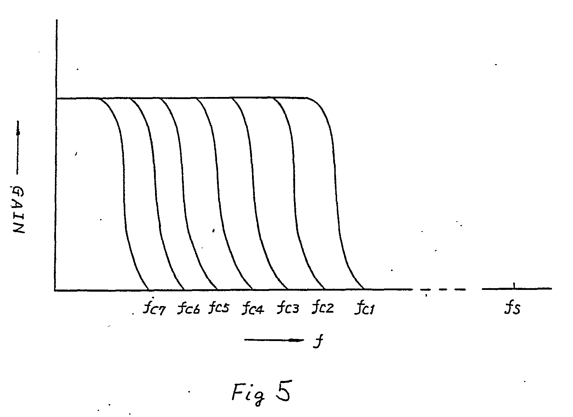

A voice signal input to input terminal 1 of Figure 3 is subjected to A/D conversion at A/D converter 6. The output of the converter 6 is input to the digital low-pass filters 16 to 22 ($n + 1$ in number) and outputs $y_1$ to $y_{n+1}$ are obtained from the digital low-pass filters 16 to 22. As in the case of Figure 2(a), the outputs of digital low-pass filters 16, 17, for example, are respectively input to square circuits 23—1, 23—2. Here, the cut-off frequencies of the digital low-pass filters 16, 17 are assumed to be $f_{c1}$, $f_{c2}$ (refer to Figure 5). The outputs of the square circuits 23—1, 23—2 are respectively input to subtraction circuit 24—1 and outputs of subtraction circuit 24—1 are accumulated in the same way as explained with reference to Figure 2(a) at accumulator 25—1.

Similar processing is carried out for the outputs of digital filters 18 to 22 to provide $n$ channel data.

It will be understood, from Figure 3 for example, that low-pass filter 17 for instance, is used in common to provide the outputs from terminals 31 and 32 (i.e. outputs for two channel frequency bands).

In Figure 5, $f_{c3}$, $f_{c4}$, $f_{c5}$, $f_{c6}$, $f_{c7}$ are cut-off frequencies of digital low-pass filters 18 to 22 respectively.

It is also apparent that the same outputs as provided by Figure 3 can be obtained in the embodiment of Figure 4. In the above explanation, digital low-pass filters are used but it will be readily appreciated that digital high-pass filters can be used instead.

Subtraction processing when digital high-pass filters are used will be explained with reference to Figure 5. An output of a filter having a cut-off frequency $f_{c6}$ is subtracted from the output of a filter having a cut-off frequency of $f_{c7}$. Also, an output of a filter having a cut-off frequency $f_{c5}$ is subtracted from an output of a filter having a cut-off frequency $f_{c6}$, and so on. In this way, an output of a filter having a higher cut-off frequency is subtracted from an output of a filter having a lower cut-off frequency. Thereafter, it is recommended that data be accumulated by accumulators. As explained above, according to this invention, it is possible to offer a small size and economical spectrum analyzer by using economical low-pass filters or high-pass filters having a small number of orders.

Claims

1. A spectrum analyzer, having a plurality of low- (or high-) pass filters (8—1, 8—2; 16 to 22) connected for receiving in parallel a signal to be analyzed, a plurality of square circuits (23—1, 23—2;

23—1 to 23—7) connected to respective filters, a plurality of accumulators (25; 25—1 to 25—6; 28—1 to 28—6), and a plurality of subtraction circuits (24; 24—1 to 24—6), characterised in that the plurality of subtraction circuits (24, 24—1 to 24—6) are connected for receiving signals directly from the outputs of respective pairs of square circuits (23—1, 23—2:23—1, 23—2; 23—2, 23—3 etc.) each for deriving the difference between the signals from the outputs of the square circuits of the pair concerned, each such pair of square circuits being connected respectively to one filter and to another filter of the next highest, or next lowest, cut-off frequency (8—1, 8—2: 16, 17; 17, 18 etc.), and in that the plurality of accumulators are connected to respective subtraction circuits (24, 24—1 to 24—6) to receive outputs therefrom.

2. A spectrum analyzer as claimed in claim 1, having an input terminal (1) for an analog signal the spectrum of which is to be analyzed and $n$ output terminals (5—1 to 5—n; 31 to 36) from which analysed data relating to $n$ respective channels is delivered when the analyzer is in use, the frequency bands of the channels being continuous (i.e. the lower frequency limit of one channel corresponding to the upper frequency limit of another), characterised by an analog-to-digital converter (6, 7) for converting the analog signal to a digital signal, $n + 1$ digital low- (or high-) pass filters (8—1, 8—2; 16 to 22) having different cut-off frequencies which correspond respectively to the upper and lower frequency limits of the $n$ channels, connected for receiving in parallel the digital signal, $n + 1$ square circuits (23—1, 23—2; 23—1 to 23—7) connected respectively for receiving the outputs of the respective filters, $n$ subtraction (24; 24—1 to 24—6) circuits connected for receiving signals directly from the outputs of respective pairs of square circuits (23—1, 23—2: 23—1, 23—2; 23—2, 23—3; 23—3, 23—4 etc.) each for deriving the difference between the signals from the outputs of the square circuits of the pair concerned, each such pair of square circuits being connected respectively to one filter and to another filter of the next highest, or the next lowest, cut-off frequency (8—1, 8—2: 16, 17; 17, 18; 18, 19 etc.) and $n$ accumulators (25; 25—1 to 25—6; 28—1 to 28—6) connected to respective subtraction circuits (24, 24—1 to 24—6) to receive outputs therefrom.

3. A spectrum analyzer as claimed in claim 1 or 2, wherein the accumulators (25; 25—1 to 25—6; 28—1 to 28—6) are complete integral circuits each arranged for accumulating values fed thereto over a period of time, for delivering an accumulated value as an output at the end of that period of time and for receiving a clear pulse, to clear the accumulated value, at the end of that period of time.

4. A spectrum analyzer as claimed in claim 1 or 2, wherein the accumulators (25; 25—1 to 25—6; 28—1 to 28—6) are imperfect integral circuits, each provided with a coefficient circuit, and each arranged for accumulating values fed thereto over a period of time and for delivering an accumulated value as an output at the end of that period of time.

5. A spectrum analyzer as claimed in any preceding claim, being a voice spectrum analyzer operable to derive channel data relating to power distribution in the voice spectrum.

**Revendications**

1. Analyseur de spectre, comportant un ensemble de filtres passe-bas (ou passe-haut) (8—1, 8—2; 16 à 22 connectés pour recevoir en parallèle un signal à analyser, un ensemble de circuits conformateurs (23—1, 23—2; 23—1 à 23—7) connectés aux filtres respectifs, un ensemble d'accumulateurs (25—; 25—1 à 25—6; 28—1 à 28—6), et un ensemble de circuits soustracteurs (24; 24—1 à 24—6), caractérisé en ce que l'ensemble de circuits soustracteurs (24, 24—1 à 24—6) sont connectés pour recevoir directement des signaux des sorties de paires respectives de circuits conformateurs (23—1, 23—2: 23—1, 23—2; 23—2, 23—3 etc.) et pour dériver chacun la différence entre les signaux des sorties des circuits conformateurs de la paire concernée, chaque paire de circuits conformateurs étant respectivement connectés à un filtre et à un autre filtre de la fréquence de coupure la plus élevée suivante, ou la plus basse suivante (8—1, 8—2; 16, 17; 17, 18 etc.); et en ce que l'ensemble des accumulateurs sont connectés aux circuits soustracteurs respectifs (24, 24—1 à 24—6) pour recevoir des signaux de sortie de ceux-ci.

2. Analyseur de spectre selon la revendication 1, caractérisé en ce que, l'analyseur comportant une borne d'entrée (1) pour un signal analogique dont le spectre doit être analysé et $n$ bornes de sortie (5—1 à 5—n; 31 à 36) à partir desquelles sont délivrées les données analysées relatives à $n$ canaux respectifs quand l'analyseur est utilisé, les bandes de fréquence des canaux étant continues (c'est-à-dire que la limite de fréquence inférieure d'un canal correspond à la limite de fréquence supérieure d'un autre), il comprend un convertisseur analogique-numérique (6, 7) pour convertir le signal analogique en un signal numérique, (n + 1) filtres numériques passe-bas (ou passe-haut) (8—1, 8—2; 16 à 22) ayant des fréquences de coupure différentes qui correspondant respectivement aux limites de fréquence supérieure et inférieure des $n$ canaux, connectés pour recevoir en parallèle le signal numérique, (n + 1) circuits conformateurs (23—1, 23—2; 23—1 à 23—7) connectés respectivement pour recevoir les signaux de sortie des filtres respectifs, $n$ circuits soustracteurs (24; 24—1 à 24—6) connectés pour recevoir directement des signaux des sorties des paires de circuits conformateurs respectives (23—1, 23—2: 23—1, 23—2; 23—2, 23—3; 23—3, 23—4, etc.) et pour dériver chacun la différence entre les signaux des sorties des circuits conformateurs de la paire concernée, chaque paire de circuits conformateurs étant respectivement connectés à un filtre et à un autre filtre de la fréquence de coupure la plus élevée suivante, ou la plus basse suivante (8—1, 8—2: 16, 17; 17, 18; 18, 19, etc.) et *n* accumulateurs (25; 25—1 à 25—6; 28—1 à 28—6) connectés aux circuits soustracteurs respectifs (24, 24—1 à 24—6) pour recevoir les signaux de sortie de ceux-ci.

3. Analyseur de spectre selon l'une quelconque des revendications 1 et 2, caractérisé en ce que les accumulateurs (25; 25—1 à 25—6; 28—1 à 28—6) sont des intégrateurs complets agencés chacun pour accumuler des valeurs qui leur sont envoyées pendant une certaine période, pour délivrer une valeur accumulée comme signal de sortie à la fin de cette période et pour recevoir une impulsion de remise à zéro, pour effacer la valeur accumulée, à la fin de cette période.

4. Analyseur de spectre selon l'une quelconque des revendications 1 et 2, caractérisé en ce que les accumulateurs (25; 25—1 à 25—6; 28—1 à 28—6) sont des intégrateurs imparfaits, prévus chacun avec un circuit de coefficient, et agencés chacun pour accumuler les valeurs qui leur sont envoyées pendant une certaine période et pour délivrer une valeur accumulée comme signal de sortie à la fin de cette période.

5. Analyseur de spectre selon l'une quelconque des revendications 1 à 4, caractérisé en ce qu'il est un analyseur de spectre vocal pouvant fonctionner pour dériver des données de canal relatives à une répartition de puissance dans le spectre vocal.

**Patentansprüche**

1. Spektrumanalysator, mit einer Anzahl von Tief- (oder Hoch-)paßfiltern (8—1, 8—2, 16 bis 22), die so angeschlossen sind, daß sie parallel zueinander ein zu analysierendes Signal empfangen, einer Anzahl von Quadrierschaltung (23—1, 23—2; 23—1 bis 23—7), die mit entsprechenden Filtern verbunden sind, einer Anzahl von Akkumulatoren (25; 25—1 bis 25—6; 28—1 bis 28—6) und einer Anzahl von Subtraktionsschaltungen (24; 24—1 bis 24—6), dadurch gekennzeichnet, daß die Anzahl von Subtraktionsschaltungen (24, 24—1 bis 24—6) so angeschlossen sind, daß sie direkt die Ausgangssignale von entsprechenden Paaren von Quadrierschaltungen (23—1, 23—2; 23—1, 23—2; 23—2, 23—3 etc.) empfangen um jeweils die Differenz zwischen den Signalen von den Ausgängen der Quadrierschaltungen des betreffenden Paars abzuleiten, wobei jedes solches Paar von Quadrierschaltungen jeweils mit einem Filter und einem anderen Filter der nächst höheren oder nächst niedrigeren Grenzfrequenz (8—1, 8—2: 16, 17; 17, 18 etc.) verbunden ist, und daß die Anzahl von Akkumulatoren mit entsprechenden Subtraktionsschaltungen (24, 24—1 bis 24—6) verbunden sind, um deren Ausgangssignale zu empfangen.

2. Spektrumanalysator nach Anspruch 1, mit einem Eingangsanschluß (1) für ein Analogsignal, dessen Spektrum analysiert werden soll, und n Ausgangsanschlüssen (5—1 bis 5—n; 31 bis 36), von denen analysierte Daten betreffend die n jeweiligen Kanäle geliefert werden, wenn der Analysator in Betrieb ist, wobei die Frequenzbänder der Kanäle kontinuierlich (d.h. die tiefere Frequenzgrenze des einen Kanals der oberen Frequenzgrenze des anderen entspricht) sind, gekennzeichnet durch einen Analog/digital-Wandler (6, 7) zur Umwandlung des Analogsignals in ein digitales Signal, n+1 digitale Tief-(oder Hoch-)paßfilter (8—1, 8—2; 16 bis 22), mit verschiedenen Grenzfrequenzen, welche jeweils der oberen bzw. der unteren Frequenzgrenze der n Kanäle entsprechen und so angeschlossen sind, daß sie parallel zueinander das digitale Signal empfangen, n + 1 Quadrierschaltungen (23—1, 23—2; 23—1 bis 23—7), die jeweils so angeschlossen sind, daß sie die Ausgangssignale der entsprechenden Filter empfangen, n Subtraktionsschaltungen (24; 24—1 bis 24—6), die zum Empfang von Signalen direkt von den Ausgängen von entsprechenden Paaren von Quadrierschaltungen (23—1, 23—2: 23—1, 23—2; 23—2, 23—3; 23—3, 23—4 etc.) geschaltet sind, um jeweils die Differenz zwischen den Signalen von den Ausgängen der Quadrierschaltungen des betreffenden Paars abzuleiten, wobei jedes Paar von Quadrierschaltungen jeweils mit einem Filter und mit einem anderen Filter der nächst höheren oder der nächst tieferen Grenzfrequenz (8—1, 8—2: 16, 17; 17, 18; 18, 19 etc.) verbunden sind, und n Akkumulatoren (25; 25—1 bis 25—6; 28—1 bis 28—6) mit entsprechenden Subtraktionsschaltungen (24, 24—1 bis 24—6) verbunden sind, um deren Ausgangssignale zu empfangen.

3. Spektrumanalysator nach Anspruch 1 oder 2, bei welchem die Akkumulatoren (25; 25—1 bis 25—6; 28—1 bis 28—6) vollständig integrierte Schaltungen sind, die jeweils angeordnet sind, um Werte zu akkumulieren, die ihnen über eine Zeitperiode zugeführt werden, um am Ende der Zeitperiode einen akkumulierten Wert als ein Ausgangssignal zu liefern und einen Löschimpuls zu empfangen, um am Ende der Zeitperiode den akkumulierten Wert zu löschen.

4. Spektrumanalysator nach Anspruch 1 oder 2, bei welchem die Akkumulatoren (25; 25—1 bis 25—6; 28—1 bis 28—6) unvollständig integrale Schaltungen sind, und jeweils eine Koeffizientenschaltung umfassen und jeweils so angeordnet sind, daß sie Werte, die ihnen über eine Zeitperiode zugeführt werden, akkumulieren um am Ende der Zeitperiode einen akkumulierten Wert als ein Ausgangssignal abzugeben.

5. Spektrumanalysator nach einem der vorhergehenden Ansprüche, welcher ein Sprachspektrumanalysator ist, der betrieben werden kann, um Kanaldaten abzuleiten, welche die Energieverteilung in dem Sprachspektrum betreffen.

Fig-1

Fig. - 2

23-1

25

24

1

6

Xn

8-1

A/D

LPF1

⊗

+ 
−

⊕

⊕

Z⁻¹

5

7

8-2

LPF2

⊗

23-2

(a)

GAIN

10

11

f

fC2   fC1

fS

(b)

0 028 103

Fig 3

Fig 4

4

Fig 5